# EUROPEAN PATENT APPLICATION

(11) **EP 1 039 511 A1**
(43) Date of publication of application: **27.09.2000**
(21) Application number: 98959158.1
(22) Date of filing: 10.12.1998
(51) Int. Cl.: H01L 21/027, G03F 7/20

(54) **PROJECTION EXPOSURE METHOD AND PROJECTION ALIGNER**

(30) Priority: 12.12.1997 JP 34278397
(71) Applicant: Nikon Corporation, Tokyo 100-8331 (JP)
(72) Inventor: HIRUKAWA, Shigeru, Nikon Corporation, Tokyo 100-8331 (JP); SUWA, Kyoichi, Nikon Corporation, Tokyo 100-8331 (JP); MURAKAMI, Seiro, Nikon Corporation, Tokyo 100-8331 (JP); NEI, Masahiro, Nikon Corporation, Tokyo 100-8331 (JP)
(74) Representative: Gill, David Alan
(86) International application number: JP9805592
(87) International publication number: WO9931717

(57) **Abstract**

A projection alignment apparatus in which a rectangular illumination region (21R) on a reticle (R) is illuminated with exposure light from an exposure light source (1), and while a pattern in the illuminated region (21R) is projected through a projection optical system (PL) onto a rectangular exposure region (21W) on a wafer (W), the reticle (R) and the wafer (W) are synchronously scanned relative to the projection optical system (PL) to transfer the pattern image of the reticle (R) onto a shot region on the wafer (W). The projection magnification of the projection optical system (PL) is set within a range of 1/5 to 1/10, and a reticle is used which is larger than, for instance, a 6 inch square (approximately 152 mm square).

## Description

### TECHNICAL FIELD

The present invention relates to a projection exposure method and a projection exposure apparatus, which are used for reducing and transferring a mask pattern through projection optical system and onto a photosensitive substrate in the lithography step in the manufacture of elements such as semiconductor elements, liquid crystal display elements, or thin film magnetic heads, and moreover relates to a method of manufacturing a device which utilizes the projection exposure apparatus.

### BACKGROUND ART

In order to achieve miniaturization of the exposure pattern and an accompanying improvement in the precision of alignment, the development of projection exposure apparatus used in the lithography step in the manufacture of semiconductor elements has progressed according to the sequence (a) to (c) outlined below.
(a) Aligner system: this system scans a wafer and a reticle serving as a mask in an integral manner relative to a non-magnification projection optical system, and the pattern image of the reticle is transferred to the entire surface of the wafer.
(b) Step and repeat system: this system transfers a reticle pattern onto one shot region of a wafer while reducing the reticle pattern to 1/5 by a projection optical system, the next shot region is moved into the exposure region by stepping the wafer stage, and the exposure is then repeated.
(c) Step and scan system: this system steps a shot region to be exposed on a wafer surface to the scan commencement position, and transfers a part of a reticle pattern image to the shot region while reducing the part by 1/4 through a projection optical system. By synchronously scanning the reticle and the wafer relative to a projection optical system in this way, the reticle pattern image is transferred to the shot region.

During the developments described above, the shift from (a) to (b) occurred because whereas in non-magnification transfers the pattern line width and positioning precision of the reticle used in the exposure had reached the limits of drawing error, carrying out reduction projection offered the advantage that the drawing error on the reticle was reduced when transferred to the wafer. Furthermore, carrying out reduction projection offers the additional advantage of improving the precision of the superposing of patterns from different layers.

Furthermore, the shift from (b) to (c) occurred mainly because the step and scan system offered the advantage that the area of each shot region on the wafer which could be exposed at one time, was larger than the exposure region that could be exposed in a stationary state through a projection optical system. Moreover, although the size of a reticle has increased from a 5 inch square (approximately 127 mm square) to a 6 inch square (approximately 152 mm square), the projection magnification has been altered to 1/4. It is due to the reason that, because the area of each shot region means is recently enlarged, even a conventional 6 inch square reticle does not enable the complete drawing of the entire original pattern which is to be exposed in the case of a projection magnification of 1/5.

As is described above, it could also be argued that the conventional projection exposure apparatus systems have been determined by factors such as (d) the drawing precision of the reticle, (e) the exposure area on a wafer (the shot region area) which can be transferred in a single exposure (the scan exposure), and (f) the size of the reticle that can be used.

Recently, due to further improvements in the level of integration of semiconductor elements, the patterns to be transferred have become even more detailed, and the exposure region area of the wafer which is to be exposed at one time has increased in size. In order to transfer a detailed pattern in the manner described, the numerical aperture of the projection optical system needs to be increased. However, simply increasing the numerical aperture causes a proportional narrowing of the focal depth in an inverse square relationship. Particularly in those cases where the exposure region to be exposed at one time is spread over a wide area, it becomes difficult to incorporate the entire exposure region within the focal depth range.

The focal depth, in addition to being optically defined using the numerical aperture, can also be defined based on the error in the line width of the actual exposure pattern. Namely on exposure, if the focus position of the resist coated wafer (the position in the optical axial direction of the projection optical system) is altered, then the shape of the space image formed on the wafer will vary, and so the line width of the resist image to be transferred to the wafer will also vary. Consequently, assuming a constant variation in the exposure, a focus position range wherein the line width variation of the pattern transferred to the wafer varies no more than ±10% from a target value, even if both the exposure and the focus position vary, is defined as the "focal depth based on line width controllability", and hereafter references to focal depth denote the focal depth based on line width controllability. Furthermore there is a predetermined drawing error in the reticle pattern, and as a result of this drawing error the plurality of pattern line widths of the reticle will differ slightly. Consequently, variations will also develop in the shape of the space image formed on the wafer based on the patterns, and this variation will be realized as a difference in the line width of the resist image.

As a result, in those cases where the drawing error of the reticle is large, the focal depth for which a predetermined pattern can be transferred with an accurate line width narrows considerably when compared with the case where the drawing error is small. If the focal depth is reduced due to reticle drawing error in this manner, then for detailed patterns which have typically been transferred with the numerical aperture at a large value and the focal depth narrowed, the problem arises of partial projection beyond the focal depth range resulting in insufficient resolution. In order to overcome this problem, consideration is made of the fact that for exposure regions of the same size, the size of the reticle pattern increases in proportion with the inverse square of the projection magnification from the reticle onto the wafer. Therefore, by reducing the projection magnification (increasing the reduction ratio) so that the pattern size on the reticle is increased even for an identical pattern size on the wafer, the effect of the reticle line width drawing error can be reduced on the wafer. However, excessive reduction of the magnification ratio to a value of less than 1/10 for example, would result in the drawing region on the reticle becoming too large, making it impossible to complete the drawing on currently obtainable reticles.

Furthermore, there is also a method wherein the pattern regions on the reticle are set at similar values, and the projection magnification is reduced. However, in such cases, if the projection magnification is reduced excessively, then the area of the region which can be transferred to the wafer at any one time is reduced, producing a problem of a reduction in throughput (the productivity) in the exposure step.

As described above, it has proved very difficult to satisfy all three of the following requirements, namely not making the focal depth too narrow due to the drawing error in the transfer of detailed patterns, accommodating the pattern to be transferred within a single reticle pattern region, and not lowering the throughput of the exposure step.

The present invention takes the above factors into consideration, and a first object of the present invention is to provide a projection exposure method and a projection exposure apparatus wherein the effect of the drawing error of the reticle pattern can be reduced, and the pattern to be transferred can be formed on a reticle of a size which is either currently available or should be available in the near future.

A second object of the present invention is to provide a projection exposure method and a projection exposure apparatus, wherein the effect of the drawing error of the reticle pattern can be reduced and the throughput of the exposure step is high.

A third object of the present invention is to provide a method of manufacturing a projection exposure apparatus such as that described above.

A fourth object of the present invention is to provide a method of manufacturing a device which utilizes the above type of projection exposure apparatus and is able to form a detailed pattern with high precision, as well as a device which is manufactured using the above type of projection exposure apparatus.

### DISCLOSURE OF THE INVENTION

A projection exposure apparatus according to the present invention is a projection exposure apparatus for projection exposing a pattern image formed on a mask (R) through a projection optical system (PL) and onto a substrate (W), wherein the projection magnification from the mask (R) of the projection optical system (PL) relative to the substrate (W) is set at a value no greater than 1/5 and no less than 1/10, and the numerical aperture of the projection optical system (PL) is set to a value of at least 0.6.

According to the present invention, because the projection magnification β is set within the range 1/5 to 1/10, for an identical drawing error on the mask, the line width error of the transfer image on the substrate can be lowered in comparison with conventional examples where the projection magnification is between 1/4 to 1/5. Consequently, the overall line width error of the pattern formed on the substrate is reduced, and the focal depth based on line width controllability widens, and so the entire pattern is able to be transferred with a high degree of line width control precision. Furthermore, because the mask pattern increases as the inverse of the projection magnification β relative to the pattern formed on the substrate, if the projection magnification β is reduced excessively then the mask pattern will grow too large, making it impossible to complete the drawing on a mask blank (a mask substrate) of a size which is either currently available or should be available in the near future. However, if the projection magnification β is greater than 1/10 then the mask pattern does not become too large, and so mask blanks can be used which are either currently available or should be available in the near future. Furthermore, by setting the numerical aperture of the projection optical system (PL) to a value of at least 0.6, the focal depth determined by the line width controllability can be set to a practical value of at least approximately 0.4 µm, as is described below.

In such a case, a stage system (22, 23, 26, 27) is provided for synchronously moving the mask (R) and the substrate (W) relative to the projection optical system (PL), and it is preferable that during exposure the mask (R) and the substrate (W) are synchronously scanned relative to the projection optical system (PL) using the projection magnification of the projection optical system as the speed ratio. This description demonstrates the application of the present invention to a synchronous scan exposure type projection exposure apparatus such as in a step and scan system. In a scan exposure type apparatus, the surface of the substrate needs only be within the focal depth range for the slit shaped exposure region on the substrate. Moreover, the width of the pattern in the scan direction can be widened to the upper limit for the mask blank being used. Therefore, because the exposure area from a single exposure can be increased, the effect of drawing error can be reduced and the throughput improved.

In the present invention, it is also preferable to use masks which exceed a 6 inch square (approximately 152 mm square) in size. By employing masks which are larger than a 6 inch square, the entire pattern for transfer can be drawn (formed) within the mask, even if the projection magnification β is set within the range 1/5>β>1/10. In such a case, it is preferable to provide a mask stage to support the large mask which is larger than a 6 inch square.

Furthermore, in the present invention, the projection magnification from the mask (R) of the projection optical system (PL) relative to the substrate (W) may be set to 1/6 for example, and the external shape of the mask set to a size of at least 9 inches square (approximately 228 mm square). In such a case, if the assumption is made of a chip pattern on the substrate of the size predicted for the next generation 1 gigabit DRAM of 27 × 13.5 mm², then the size of the mask pattern in the case of a projection magnification of 1/6 would be 162 × 81 mm², whereas the size of the mask pattern in the case of a conventional projection magnification of 1/4 would be 108 × 54 mm². Consequently, if a conventional 6 inch square mask is used, then allowing for the space for alignment marking, a projection magnification of 1/6 would not enable the drawing of the entire mask pattern of a single chip, whereas a projection magnification of 1/4 would allow the drawing of the entire mask pattern of a single chip. In such a case, assuming an identical level of drawing error, the line width error on the substrate at a projection magnification of 1/6 would be 2/3 that of the line width error at a projection magnification of 1/4. However, with a 6 inch square mask, this reduction in the effect of line width error could not be realized.

In contrast, when a 9 inch square (approximately 228 mm square) mask which are recently becoming more readily available is used, at a projection magnification of 1/6 the mask pattern of two chips can be drawn, whereas at a projection magnification of 1/4 the mask pattern of three chips can be drawn. Consequently, by setting the projection magnification to 1/6 and using a 9 inch square mask, the effect of drawing error can be reduced to 2/3 that observed with a projection magnification of 1/4. Moreover, because two mask patterns can be drawn, a higher level of throughput can be achieved. In such a case, the focal depth based on line width controllability deepens due to the reduction in the effect of the drawing error. Therefore, the line width control precision for the transfer pattern can be improved.

Furthermore, in the case where the size of the exposure region (the chip pattern) on the substrate is 25 × 33 mm², the size of the mask pattern at a projection magnification of 1/4 would be 100 × 132 mm², and the size of the mask pattern at a projection magnification of 1/6 would be 150 × 198 mm². Consequently, if the region required outside the pattern for alignment marking is also taken into consideration, then at a projection magnification of 1/4, use of a 6 inch (approximately 152 mm) square mask blank would be suitable, whereas at a projection magnification of 1/6, a 9 inch (approximately 228 mm) square mask blank could be used. Moreover, use of a mask blank even larger than a 9 inch square would enable the handling of even larger chip patterns.

In the case where for example a projection magnification of 1/8 is used in order to further reduce the effect of mask drawing error, further reduction of the projection magnification (increase in the reduction ratio) would require a mask equivalent to 200 × 264 mm² for a 25 × 33 mm² substrate, which is equivalent to a 12 inch (approximately 304 mm) square mask blank. Consequently, for projection magnification values β between 1/8 and 1/10 (1/8≧β>1/10), it is preferable to use a mask of at least 12 inches square.

Furthermore, in the present invention, in the cases where the projection magnification β is set to 1/6, simulations by the inventors revealed that when KrF excimer laser radiation (wavelength 248 nm) of wavelength greater than 200 nm was used as the illuminating light for exposure (the exposure light), the numerical aperture of the projection optical system required to produce a practical focal depth, determined by the line width controllability, of at least 0.4 µm, is approximately 0.65 or greater. Similarly, when ArF excimer laser radiation (wavelength 193 nm) of wavelength less than 200 nm was used as the exposure light, the numerical aperture of the projection optical system required to produce a practical focal depth, determined by the line width controllability, of at least 0.4 µm, is approximately 0.6 or greater. Consequently, in those cases where the projection magnification β is set to 1/6, then when KrF excimer laser radiation or ArF excimer laser radiation is used as the exposure light, the numerical aperture of the projection optical system should preferably be set to a value of at least 0.65, or at least 0.6 respectively. Moreover, in those cases where ArF excimer laser radiation is used, the projection magnification β is 1/6, and the numerical aperture of the projection optical system is set to 0.6, then by carrying out 2/3 orbicular zone illumination with the coherence factor σ set within the range 0.75 to 0.8, the focal depth based on line width controllability can be particularly deepened.

Furthermore, when 2/3 orbicular zone illumination is to be performed, by providing, in the light path for the illuminating light beam of the exposure light, an aperture stop comprising a ring shaped aperture with the inner diameter 2/3 that of the outer diameter, orbicular zone illumination can be realized quite easily.

A method of manufacturing a projection exposure apparatus according to the present invention is a method of manufacturing a projection exposure apparatus for projection exposing a pattern image formed on a mask (R) through a projection optical system and onto a substrate (W), wherein a mask stage (22, 23) is supplied for supporting the mask, a substrate stage (28) is supplied for supporting the substrate, a projection optical system (PL), in which the projection magnification from the mask (R) relative to the substrate (W) is set at a value no greater than 1/5 and no less than 1/10, is mounted on a predetermined support base, and the numerical aperture of the projection optical system (PL) is set to a value of at least 0.6. Moreover, the method of manufacture can also be altered in order to accommodate the configurations of the various projection exposure apparatus of the present invention described above.

A projection exposure method according to the present invention is a projection exposure method for projection exposing a pattern image formed on a mask (R) through a projection optical system (PL) and onto a substrate (W), wherein a mask for which the external shape is at least a 9 inch square is used as the mask, the projection magnification from the mask (R) of the projection optical system (PL) relative to the substrate (W) is set at a value no greater than 1/5 and no less than 1/10, and the numerical aperture of the projection optical system (PL) is set to a value of at least 0.6.

According to this invention, because the projection magnification β is set within the range 1/5 to 1/10, for an identical drawing error on the mask, the focal depth based on line width controllability widens. Therefore, the entire pattern is able to be transferred with a high degree of line width control precision in comparison with conventional examples where the projection magnification is between 1/4 to 1/5. Furthermore, the mask pattern increases as the inverse of the projection magnification β relative to the pattern formed on the substrate. However using a 9 inch square enables drawing to be carried out, including the margin left for alignment marking. Moreover, by setting the numerical aperture to a value of at least 0.6, as described above, the focal depth determined by the line width controllability can be set to a practical value of at least approximately 0.4 µm. In such a case, when the projection magnification β is between 1/8 and 1/10 (1/8≧β > 1/10), a 12 inch square mask should preferably be used.

A method of manufacturing a device according to the present invention is a method of manufacturing a device which utilizes a projection exposure apparatus according to the present invention. This method comprises: a first step (step 103) for applying a photosensitive material to the substrate (W), a second step (step 105) for projection exposing a pattern image of the mask (R) through the projection optical system (PL) and onto the substrate (W), a third step (step 106) for developing the substrate (W), and a fourth step (step 107) for forming an uneven pattern on the substrate (W) while using as a mask the photosensitive material remaining after the third step. In this invention, because the projection magnification of the projection optical system (PL) is set to a value between 1/5 and 1/10, the effect of mask pattern drawing error is reduced. Therefore, detailed patterns can be formed with high precision, enabling the manufacture of high performance devices.

Furthermore, a device according to the present invention is a device which has been manufactured using a projection exposure apparatus manufactured by the method of manufacturing a projection exposure apparatus according to the present invention described above. By using such a projection exposure apparatus, high performance devices are achievable.

### BRIEF DESCRIPTION OF THE DRAWINGS

FIG. 1 is a perspective diagram showing a projection exposure apparatus used in an example of an embodiment of the present invention.
FIG. 2(A) is a cross-sectional view showing the use of a 6 inch reticle in the case of a single take.
FIG. 2(B) is a cross-sectional view showing the use of a 9 inch reticle in the case of a triple take.
FIG. 2(C) is a cross-sectional view showing the use of a 9 inch reticle in the case of a double take.
FIG. 3(A) is a diagram showing a line and space pattern with no drawing error.
FIG. 3(B) is a diagram showing a line and space pattern in which the shielded portion is wide.
FIG. 3(C) is a diagram showing a line and space pattern in which the shielded portion is narrow.
FIGS. 4(A1) to 4(B4) are graphs showing the calculated results of the focal depth values based on line width controllability for projection magnification values of 1/4, 1/6, 1/8 and 1/10, using either KrF excimer laser radiation or ArF excimer laser radiation as the exposure light.
FIG. 5 is a flow chart showing one example of a circuit pattern manufacturing process according to an embodiment of the present invention.

### BEST MODE FOR CARRYING OUT THE INVENTION

As follows is a description of one example of a preferred embodiment of the present invention, with reference to the drawings.

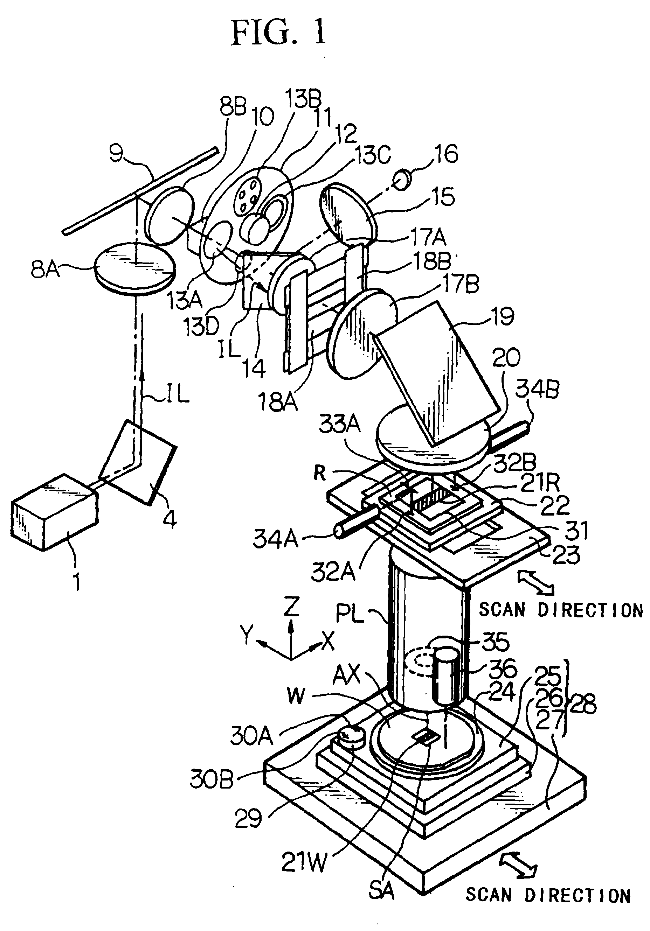

FIG. 1 shows a step and scan type projection exposure apparatus used in the embodiment. As shown in FIG. 1, an exposure light source 1 comprising a KrF excimer laser light source emits an exposure light beam IL of pulse laser radiation of wavelength 248 nm, and the exposure light beam IL is reflected by a minor 4 for bending the optical path. The exposure light beam IL is then passed through a first lens 8A and reflected off a minor 9 for bending the optical path, and is passed through a second lens 8B and into a fly eye lens 10. The cross-sectional shape of the exposure light beam IL is shaped by a beam reshaping optical system constructed of the first lens 8A and the second lens 8B so as to match the plane of incidence of the fly eye lens 10. As a suitable exposure light beam, other excimer laser radiation such as ArF excimer laser radiation (wavelength 193 nm), F₂ laser radiation (wavelength 157 nm), the higher harmonics of YAG laser radiation, or the i line ray of a mercury lamp (wavelength 365 nm), can be used.

An illumination system aperture stop plate 11 is arranged at the exit plane of the fly eye lens 10 in a manner which allows free rotation of the plate 11. Around the rotational axis of the aperture stop plate 11 are formed respectively, a typical illumination circular aperture stop 13A, an aperture stop 13B for transformed illumination comprising a plurality of small eccentric apertures, a ring shaped aperture stop 13C for orbicular zone illumination, and a small circular aperture stop 13D for use with small coherence factors (σ). By rotating the aperture stop plate 11 with a drive motor 12, the desired illumination system aperture stop can be positioned at the exit plane of the fly eye lens 10.

A portion of the exposure light beam IL that has passed through the aperture stop at the exit plane of the fly eye lens 10 is reflected by a beam splitter 14 and passes through a condenser lens 15 and into an integrator sensor 16 comprising a photoelectric detector. A computer of a main control system (which is not shown in the figure) is able to indirectly monitor the illumination intensity (the pulse energy) of the exposure light beam IL at the surface of a wafer W, and the estimated exposure at each point on the wafer W, based on a detection signal from the integrator sensor 16. The exposure light beam IL which penetrates the beam splitter 14 passes through a first relay lens 17A, and then passes through a sequential fixed field stop (a reticle blind) 18A, and a movable field stop 18B. The fixed field stop 18A and the movable field stop 18B are positioned in close proximity, and are substantially positioned at a conjugate surface with the pattern surface of a reticle R which is to be transferred. The fixed field stop 18A is the field stop which defines the shape of the rectangular illumination region on the reticle R, and the movable field stop 18B is used at the commencement of, and the completion of, the scan exposure, to close off sections of the illumination region to ensure that exposure of unnecessary portions does not occur.

The exposure light beam IL that has passed through the movable field stop 18B, passes through a second relay lens 17B, is reflected off a minor 19 for bending the optical path, and passes through a condenser lens 20, and then illuminates a rectangular illumination region 21R within a pattern region 31 which is provided on the pattern surface (the lower surface) of the reticle R. The exposure light beam IL causes the pattern within the illumination region 21R of the reticle R to be passed through the projection optical system (PL) and reduction projected onto an exposure region 21W of a photoresist coated wafer W, with a predetermined projection magnification β (in this embodiment, β is within the range 1/5 to 1/10). An aperture stop 35 is positioned inside the projection optical system PL within an optical Fourier transform plane corresponding to the pattern surface of the reticle R. The numerical aperture NA is set by the aperture stop 35. In the following description, the Z axis is defined as being parallel with the optical axis AX of the projection optical system PL, the Y axis is defined as being within the plane perpendicular to the Z axis and in the direction of the scan, and the X axis is defined as being the non-scan direction which is perpendicular to the direction of the scan.

The reticle R is supported on a reticle stage 22, and the reticle stage 22 is mounted on a reticle base 23 in such a manner that enables continuous movement of the reticle stage 22 in the Y direction by using a linear motor. Moreover, there is also a mechanism built into the reticle stage 22 which enables minor movements of the reticle R in the X direction, the Y direction, or in a rotational direction. In contrast, the wafer W is retained by attraction on the top of a wafer holder 24, and the wafer holder 24 is fixed onto a Z tilt stage 25 which controls the focus position of the wafer W (the position in the Z direction) and the tilt angle. The Z tilt stage 25 is fixed to an XY stage 26. The XY stage 26 carries out continuous movement of the Z tilt stage 25 (the wafer W) across a base 27 in the Y direction by using a feed screw system or a linear motor system or the like, as well as carrying out stepping movements in the X direction and Y direction. A wafer stage 28 is constructed from the Z tilt stage 25, the XY stage 26, and the base 27. The positions of the reticle stage 22 (the reticle R) and the Z tilt stage 25 (the wafer W) are measured with a high degree of precision using a laser interferometer (not shown in the figure). Based on the results of the measurements, the movement of the reticle stage 22 and the wafer stage 28 is controlled by the aforementioned main control system (not shown in the figure).

During synchronous scanning, the reticle R is scanned at a velocity of VR, via the movement of the reticle stage 22, in a +Y (or -Y direction) direction relative to the illumination region 21R, while synchronously the wafer W is scanned at a velocity of β·VR (where β is the projection magnification from the reticle R to the wafer W), via the movement of the XY stage 26, in a -Y (or +Y direction) direction relative to the exposure region 21W. As a result the pattern image within the pattern region 31 of the reticle R is sequentially transferred to a single shot region SA on the wafer W. Following the transfer, the XY stage 26 is stepped to move the next shot region on the wafer W to the scan commencement position, and the next scan exposure is conducted. In the step and scan method this operation is repeated until each shot region on the wafer W has been exposed. During the exposure process, the amount of exposure for each shot region is controlled based on the detection signals from the integrator sensor 16.

In order to carry out the type of exposure described above, it is necessary to first conduct an alignment of the reticle R and the wafer W. Consequently, a reference mark member 29 comprising a glass substrate is fixed in a position proximate to the wafer holder 24 on the Z tilt stage 25, and reference marks 30A, 30B such as a cross mark made of a chrome film are formed on top of the reference mark member 29. An image processing type alignment sensor 36 for detecting the position of wafer marks attached to each shot region on the wafer W is also provided on the side surface of the projection optical system PL. A reference mark (not shown in the drawing) for the alignment sensor 36 is also provided on the reference mark member 29. Furthermore, alignment marks 32A, 32B are also formed on opposite sides of the pattern region 31 of the reticle R, in a positional relationship generated by converting the positional relationship of the reference marks 30A, 30B via the projection magnification from the wafer to the reticle. Image processing type reticle alignment microscopes 34A, 34B are provided to view the alignment marks 32A, 32B via minors 33A and so on.

When the alignment of the reticle R is carried out, as an example, while the center of the reference marks 30A, 30B are positioned at substantially the center of the exposure field of the projection optical system PL, the reference marks 30A, 30B are illuminated from below with an illuminating light beam of the same wavelength region as the exposure light IL. Images of the alignment marks 30A, 30B are formed in the vicinity of the alignment marks 32A, 32B, and the degree of misalignment of the alignment mark 32A relative to the image of the reference mark 30A is detected by one of the alignment microscopes 34A, while the degree of misalignment of the alignment mark 32B relative to the image of the reference mark 30B is detected by the other alignment microscope 34B. Positioning of the reticle R relative to the wafer stage 28 is conducted by positioning the reticle stage 22 so as to correct the detected misalignments. At this point, by observing corresponding reference marks with the alignment sensor 36, the spacing (the baseline amount) between the detection center of the alignment sensor 36 and the center of the pattern image of the reticle R can be calculated. In the case of exposure with superposition onto the wafer, by driving the wafer stage 28 based on the position corrected based on the detection result from the alignment sensor 36 and the calculated baseline amount, the scan exposure can be conducted with a high degree of superposing precision of the pattern image of the reticle R onto each shot region on the wafer.

Next is a description of the exposure of a circuit pattern of a predetermined semiconductor device onto each shot region of a wafer W, using a projection exposure apparatus of the present embodiment. The description below describes the exposure of a DRAM, which is a semiconductor device in which the circuit pattern is detailed, and moreover in which the area of the smallest unit of circuit pattern (hereafter referred to as an "element") is comparatively small. In the case of DRAM, the degree of integration of the circuit pattern increases approximately four fold every three years, and at the same time the size of a single element is reduced to about 70%. However, the memory capacity increases approximately four fold, with an accompanying four fold increase in the number of elements, and so the area of a single chip pattern has been expanding. Furthermore, if the structure of each element can be reduced in size for an identical degree of integration, then the number of chip patterns that can be formed on a single wafer will increase. Therefore, generally so called "second generation" chip patterns are manufactured in which even for an identical degree of integration, the size of an element has been reduced to approximately 80% of the original size. The area of these second generation chip patterns will reduce in accordance with the degree of miniaturization of the elements.

As an example, according to prediction mapping from the American SIA (Semiconductor Industries Association), a second generation 1 gigabit DRAM chip pattern will be 27 × 13.5 mm². Furthermore, in those cases where the projection magnification β from the reticle to the wafer is the reduction ratio, then relative to the area of each chip pattern to be exposed on the wafer, the original pattern (reticle pattern) on the reticle will be magnified by a factor of 1/β. Consequently, in the case of the exposure of a chip pattern of 27 × 13.5 mm², if the projection magnification is 1/4, the size of the reticle pattern will be expanded to 108 × 54 mm², whereas if the projection magnification is 1/6, the size of the reticle pattern will be expanded to 162 × 81 mm². For the reticle R shown in FIG. 1, the reticle pattern is the pattern formed within the pattern region 31, and in actuality there must also be a margin provided around the edge of the pattern, for forming the alignment marks 32A, 32B.

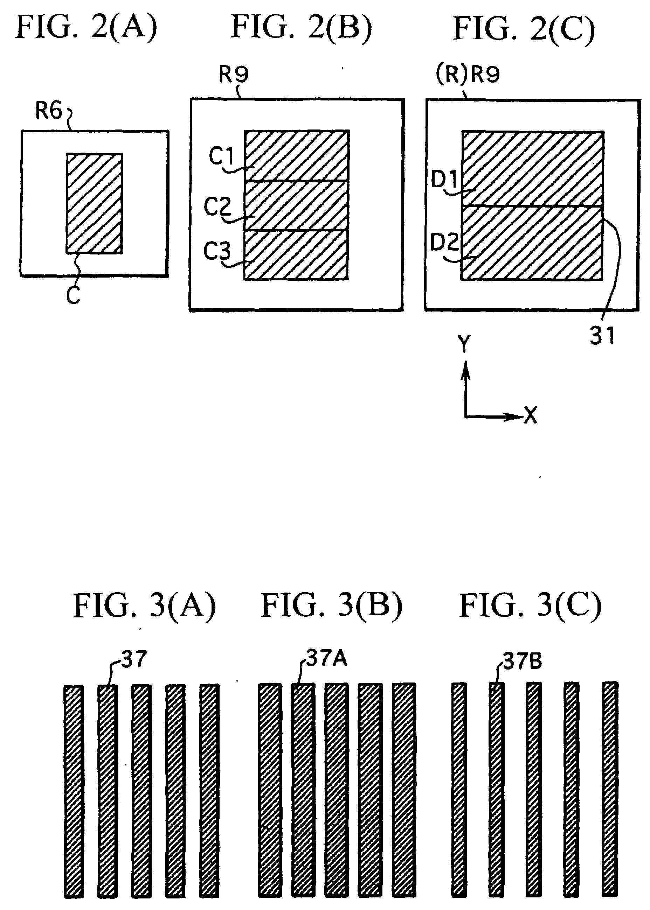

Consequently, for the case shown in FIG. 2(A) wherein the projection magnification is 1/4, and a 6 inch (approximately 152 mm) square reticle (6 inch reticle) R6 is used, the case shown in FIG. 2(B) wherein the projection magnification is 1/4, and a 9 inch (approximately 228 mm) square reticle (9 inch reticle) R9 is used, and the case shown in FIG. 2(C) wherein the projection magnification is 1/6, and the 9 inch reticle R9 is used, the number of reticle patterns for forming a second generation chip pattern of a 1 gigabit DRAM which can be drawn on a single reticle are one, three, and two respectively. Namely, with the 6 inch reticle R6 of FIG. 2(A), a single reticle pattern C which is four times the size of 27 × 13.5 mm² is formed, with the 9 inch reticle R9 of FIG. 2(B), three reticle patterns C1, C2, C3 which are four times the size of 27 × 13.5 mm² are formed, and with the 9 inch reticle R9 of FIG. 2(C), two reticle patterns C1, C2 which are six times the size of 27 × 13.5 mm² are formed.

The use of a 6 inch reticle with a projection magnification of 1/6 is not possible, as a single reticle pattern of six times the size of 27 × 13.5 mm² cannot be drawn entirely within the effective region. Furthermore, if the projection magnification is set to 1/8, the size of the reticle pattern increases to 216 × 108 mm², and so even with a 9 inch reticle only a single chip pattern can be drawn on one reticle. Based on the above considerations, the conducting of an exposure of a second generation chip pattern of a 1 gigabit DRAM can be effectively carried out using a 9 inch reticle and at a projection magnification of either 1/4 or 1/6.

However, when a 9 inch reticle is used with a projection magnification of either 1/6 or 1/4 to conduct an exposure of a second generation chip pattern of a 1 gigabit DRAM, the number of chips which can be transferred with a single exposure is two and three respectively (refer to FIG. 2(B) and FIG. 2(C)). Therefore, there is a danger of a difference developing in the processing time per wafer and consequently in the throughput of the exposure process (the number of wafers processed per time unit). However, in practice the processing time comprises not only the narrow definition of exposure time covering the time for which the reticle pattern image is exposed on the wafer, but also incorporates factors such as alignment time, and the time taken to move the stages. Consequently, in terms of the processing time for a single wafer, the processing time in the case of a projection magnification of 1/6 is not simply 3/2 times that of the processing time in the case of a projection magnification of 1/4, and in practice the processing time for the former, is less than 3/2 times that of the latter, and approaches 1.

However, setting the projection magnification to 1/6 enables a reduction in the effect of reticle pattern drawing error in comparison with the case where the projection magnification is 1/4. To analyze this difference quantitatively, consider the line width of a second generation circuit pattern of a 1 gigabit DRAM which is said to be between 160 to 150 nm. The following description considers a representative case of the exposure onto a wafer of a line and space pattern image of line width 150 nm.

In the case where the projection magnification is 1/4, a line width of 150 nm will become 600 nm on the reticle, whereas at a projection magnification of 1/6, a line width of 150 nm will become 900 nm on the reticle. With current reticle manufacturing technology, the pattern line width error on the reticle is considered to be of the order of ±35 nm. Assuming that advancements in reticle manufacturing technology will result in a line width error, resulting from a reticle drawing error (manufacturing error) during mass production of a second generation 1 gigabit DRAM of ±25 nm, then the converted line width error on the wafer will be ±2.5 nm at a projection magnification of 1/10, ±3.13 nm at a projection magnification of 1/8, ±4.17 nm at a projection magnification of 1/6, and ±6.25 nm at a projection magnification of 1/4. When the reticle pattern line width differs with the drawing error in this manner, the shape of the image formed on the wafer by reduction projection of the reticle pattern will also differ. In this case, if a positive resist is used, then the thicker the line width of the shielded portion of the reticle pattern, the thicker the line width of the resist image formed on the wafer following developing will become.

Thus, if the line and space pattern 37 shown in FIG. 3(A) is taken as the original reticle pattern with no error, wherein the diagonally striped sections are the shielded portions, then if the reticle drawing error produces a widening of the line width of the shielded portions, the line and space pattern 37A shown in FIG. 3(B) is obtained, whereas if the line width of the shielded portions is narrowed, the line and space pattern 37B shown in FIG. 3(C) is obtained. Furthermore, when a positive resist is used, if the line and space pattern 37A of FIG. 3(B) is used as the reticle pattern then the line width of the resist image will widen, whereas if the line and space pattern 37B of FIG. 3(C) is used as the reticle pattern the line width of the resist image will narrow.

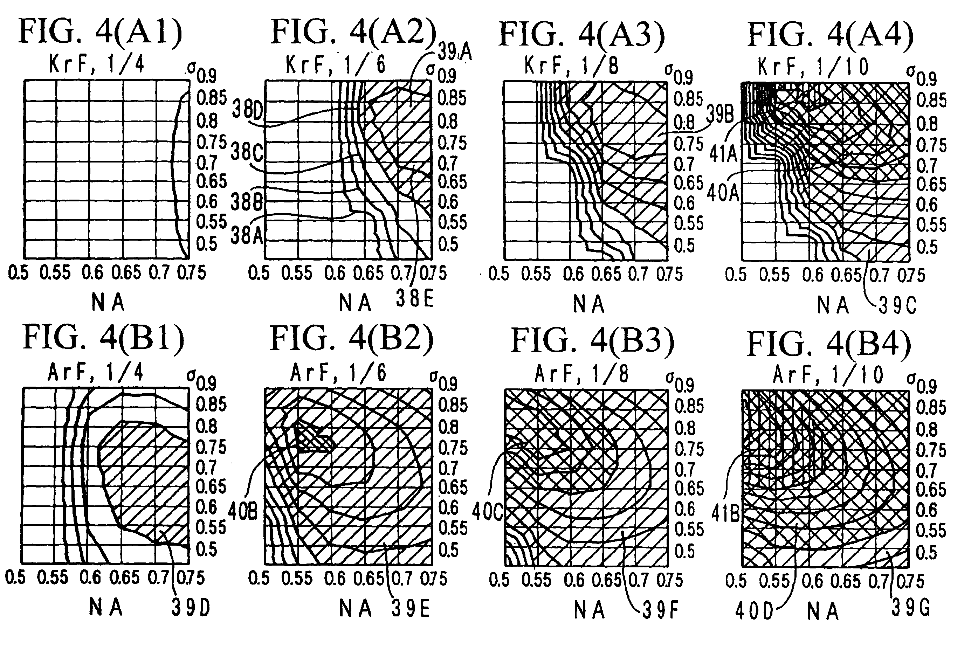

To enable further simplification, in order to remove the effect of line width variation during resist developing, the amount of exposure which results in a width of 150 nm for the space image at the best focus position of the projection optical system is set as the reference exposure. Then, taking into consideration the exposure controllability and the stability of the developing process and the like, and assuming that the actual amount of exposure will vary ±5% relative to the reference exposure, then for those cases where a drawing error in the reticle pattern converts to an error on the wafer of ±2.5 nm (in the case of a projection magnification of 1/10), ±3.13 nm (in the case of a projection magnification of 1/8), ±4.17 nm (in the case of a projection magnification of 1/6), or ±6.25 nm (in the case of a projection magnification of 1/4), the results of calculations by computer simulation of the focal depth where the final wafer line width error is ±15 nm (equivalent to ±10% of the line width) are shown below. In the calculations described below either KrF excimer laser radiation (wavelength 248 nm) or ArF excimer laser radiation (wavelength 193 nm) was used as the exposure light beam, a half tone reticle of 8% transmission (the transmission ratio of the shielded portions is 8%) was used as the reticle, and the illumination optical system used for the exposure was a 2/3 orbicular zone illumination type. Here, 2/3 orbicular zone illumination refers to the use of an aperture stop with a ring shaped aperture in which the inner diameter is 2/3 that of the outer diameter, as the aperture stop of the illumination system. Furthermore, the results obtained for the focal depth based on line width controllability in cases where the numerical aperture NA of the projection optical system was varied within the range 0.50 to 0.75, and the coherence factor σ of the illumination optical system (in the case of a ring shaped aperture stop, the σ value of the outer diameter) was varied within the range 0.45 to 0.90, are shown in the contour maps of FIGS. 4(A1) to 4(B4).

FIG. 4(A1) through FIG. 4(A4) show the focal depth contour maps for projection magnifications of 1/4, 1/6, 1/8, and 1/10 respectively with KrF excimer laser radiation used as the exposure light, and FIG. 4(B1) through FIG. 4(B4) show the focal depth contour maps for projection magnifications of 1/4, 1/6, 1/8, and 1/10 respectively with ArF excimer laser radiation is used as the exposure light. In the contour maps, the horizontal axis represents the numerical aperture NA of the projection optical system, and the vertical axis represents the σ value of the illumination optical system, and the spacing between contour lines corresponds with a difference in focal depth of 0.1 µm.

For example, in the case of KrF excimer laser radiation and a projection magnification of 1/6 shown in FIG. 4(A2), the contour lines 38A to 38E represent focal depth values of 0.1 to 0.5 µm respectively, and the region between the contour lines 38A and 38B represents a region for which the focal depth is between 0.1 to 0.2 µm. The hatched section 39A beyond the contour line 38D represents a region for which the focal depth is between 0.4 to 0.6 µm. Similarly, the hatched sections 39B, 39C, and 39D to 39G of FIG. 4(A3), FIG. 4(A4), and FIG. 4(B1) through FIG. 4(B4) respectively represent focal depth values of at least 0.4 µm. Furthermore, the double hatched sections 40A, and 40B to 40D of FIG. 4(A4), and FIG. 4(B2) through FIG. 4(B4) respectively represent focal depth values of 0.8 to 1.2 µm, and the triple hatched sections 41A, 41B of FIG. 4(A4) and FIG. 4(B4) respectively represent focal depth values of 1.2 to 1.6 µm.

First, as is evident from FIG. 4(A1) through FIG. 4(A4), in those cases where KrF excimer laser radiation was used, at a projection magnification of 1/4, even if a projection optical system with a numerical aperture NA of 0.75 is used, the maximum focal depth achievable is only 0.2 µm, whereas if the projection magnification is set to 1/6, then at numerical aperture values NA of 0.65 or 0.70, maximum focal depth values of approximately 0.5 µm and 0.6 µm respectively are achievable. In this regard, it is extremely difficult to deliver a total focus error, which incorporates such factors as the stability of the autofocus control of the projection exposure apparatus, the amount of defocus within the exposure region, wafer flatness, and process differences, of only 0.2 µm. However, it is possible to achieve a total focus error of approximately 0.4 µm. In FIG. 4(A1) through FIG. 4(A4), the hatched sections 39A to 39C, 40A and 41A represent practical focal depth values of at least 0.4 µm.

Consequently, on the assumption of a line width error on the reticle of ±25 nm, the focal depth achievable at a projection magnification of 1/4 (FIG. 4(A1)) is insufficient. In contrast, if the projection magnification is altered to 1/6, then provided a projection optical system with a numerical aperture NA of at least 0.65 is used, by selecting a suitable σ value, a focal depth of at least 0.4 µm, which is sufficient for practical use, is achievable. Therefore, pattern transfer can be conducted with good line width controllability.

Next, as is evident from FIG. 4(B1) through FIG. 4(B4), in those cases where ArF excimer radiation was used, in order to achieve a focal depth of at least 0.4 µm, then at a projection magnification of 1/4, a projection optical system with a numerical aperture NA of at least 0.62 is necessary, whereas at a projection magnification of 1/6 a projection optical system with a numerical aperture NA of 0.60 is sufficient. Because the shorter the exposure wavelength becomes, the more difficult it becomes, in terms of design and manufacture, to produce projection optical systems with large numerical apertures, even in those cases where an ArF excimer laser is used as the exposure light source, it is still more practical and advantageous in terms of focal depth based on line width controllability, to use a projection magnification of 1/6. Moreover, as is evident from FIG. 4(B2), in the case where ArF excimer laser radiation is used and the projection magnification is set to 1/6, then at a numerical aperture NA of 0.6 and a σ value in the vicinity of 0.75 to 0.8, a region for which the focal depth is at least 0.8 µm exists, as indicated by the double hatched section 40B. Consequently, by using a numerical aperture NA of approximately 0.6 and setting the σ value within the range 0.75 to 0.8, it is possible to achieve a very large focal depth.

The above investigations show that in the case of either KrF excimer laser radiation or ArF Excimer laser radiation being used as the exposure light, then compared with a projection magnification of 1/4, setting the projection magnification to 1/6 is advantageous in terms of the focal depth based on line width controllability.

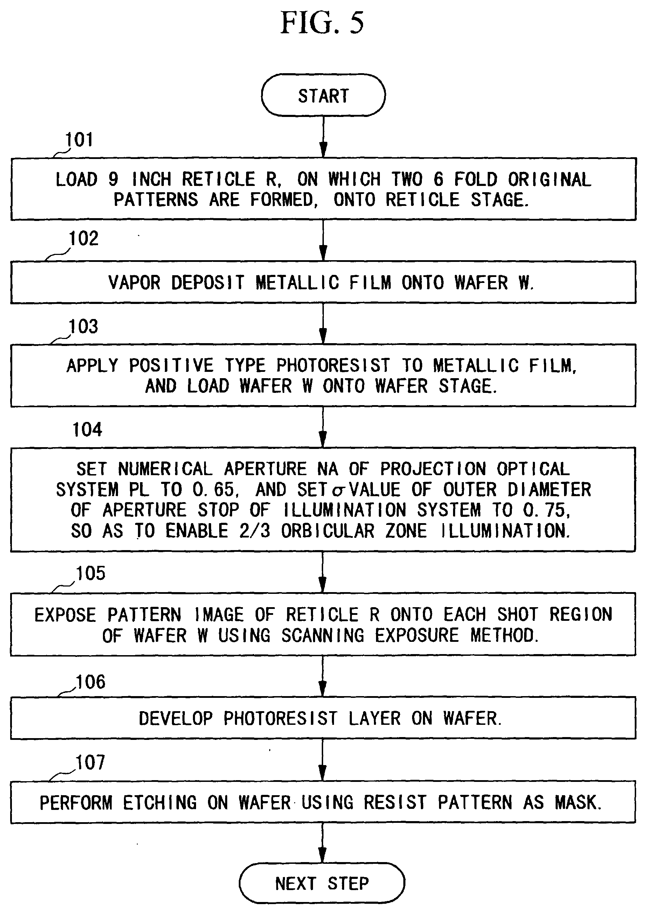

As follows is a description, with reference to the flowchart of FIG. 5, of one example of the operation of conducting an exposure of a second generation chip pattern of a 1 gigabit DRAM, which is predicted to be 27 × 13.5 mm² in size, using the projection exposure apparatus of FIG. 1. For this example, a 9 inch reticle is used for the reticle R shown in FIG. 1, and the projection magnification β, from the reticle of the projection optical system PL to the wafer, is set to 1/6. Furthermore, on the pattern region 31 of the reticle R is formed an original pattern comprising two reticle patterns D1, D2 of a size equivalent to six times 27 × 13.5 mm², in the same manner as the 9 inch reticle R9 shown in FIG. 2(C).

In step 101 of FIG. 5, the 9 inch square reticle R, on which is formed the original pattern comprising two chip patterns at six fold size, is loaded outo the reticle stage 22 of FIG. 1. In the next step 102, a metallic film is vapor deposited on the water to be exposed (wafer W). Then in step 103, following the application of a positive type photoresist (a positive resist) to the metallic film on the wafer W, the wafer W is loaded onto the wafer holder 24 of the projection exposure apparatus of FIG. 1. At this point, pre-alignment is carried out using the external shape as a reference. Then, as described above, the pattern region 31 of the reticle R is aligned relative to the wafer stage 28 by using the reference mark member 29 and the reticle alignment microscopes 34A, 34B. In the case of superposed exposure, the position of a wafer mark of a predetermined shot region on the wafer W is detected via the alignment sensor 36, and the detection result then used to calculate the positioning coordinates of each shot region, with the alignment of each shot region on the wafer W being carried out based on these results.

Next, at step 104, in order to achieve a focal depth of at least 0.4 µm based on the results from FIG. 4(A2), the numerical aperture NA of the projection optical system PL is set to 0.65, and the aperture stop plate 11 is rotated so as to set the orbicular zone illumination aperture stop 13C at the exit plane of the fly eye lens 10. In the ring shaped aperture of the aperture stop 13C, the σ value of the outer diameter is 0.75, and the inner diameter is 2/3 that of the outer diameter, thereby making 2/3 orbicular zone illumination possible. At the next step 105, the pattern image on the reticle R is exposed on each shot region of the wafer W using a scan exposure method.

Subsequently, at step 106, the photoresist on the wafer W is developed. As a result, a convex resist pattern, which corresponds with the shielded pattern image within the reticle pattern D1, D2 of FIG. 2(C), is left on each shot region of the wafer W. Next, at step 107, the metallic film on the wafer undergoes etching, using the resist pattern as a mask. Then removing the resist pattern, a desired circuit pattern is formed on each shot region of the wafer W. The wafer W is then moved to a formation step for forming the circuit pattern of the next layer. In the present example, because the focal depth is at least 0.4 µm, the desired circuit pattern can be formed on each shot region of the wafer W with a high degree of line width control precision.

Furthermore, in order to manufacture a complete semiconductor device, then in addition to the steps of FIG. 5, other steps such as: a step for designing the function and performance of the device, a step for manufacturing a reticle based on the designing step, a step for producing a wafer from a silicon material, a step for assembling the device (including a dicing step, a bonding step and a packaging step), and an inspection step need to be implemented.

The above embodiment described the application of the present invention to the exposure of a second generation chip pattern of a 1 gigabit DRAM. However the present invention is not limited to this embodiment, and can, of course, also be applied to other devices such as other DRAM or CPU chips, for which the line width or the chip size may be different. For example, in the case of a chip pattern of 25 × 33 mm², the six fold expanded original pattern will be 150 × 198 mm². Consequently, in the case of a projection magnification of 1/6, a 9 inch (approximately 228 mm) square reticle will be sufficient to form the original pattern and alignment markings.

Furthermore, in the embodiment described above, the projection magnification was set to 1/6. However as is evident from FIGS. 4(A1) to 4(B4), by setting the projection magnification to 1/8 or 1/10, the focal depth based on line width controllability will widen even further. Consequently, in the near future, when reticles larger than a 9 inch square become viable, the projection magnification could also be set to 1/8. Hence, by setting the projection magnification of the reticle of the projection optical system relative to the wafer to a value within a range between 1/5 and 1/10, a focal depth based on line width controllability can be achieved which is greater than conventionally achievable values.

Furthermore, in the above embodiment the effect of reticle drawing error was determined using a line and space pattern. However, the appearance of an error in the transferred resist line width due to a reticle drawing error is not limited to line and space patterns, and other patterns such as isolated line, isolated space, and hole patterns produce the same effect.

Moreover, in the above embodiment, the projection optical system is assumed to be a lens based system (a refraction system). However in addition to refraction systems, projection optical systems based on a reflection system or a catadioptric system (a reflective refraction system) can also be used, and by optimization of the projection magnification, good focal depth values can be achieved. With regards the type of reticle used, in addition to standard reticles and half tone reticles, phase shift reticles such as a Shibuya-Levenson type reticle can also be used and applied to the present invention.

Furthermore, the projection exposure apparatus of the above embodiment can be manufactured by assembling the illumination optical system comprising a plurality of lenses and the projection optical system into the main body of the exposure apparatus and performing optical adjustment, as well as attaching the reticle stage and the wafer stage, each of which comprises a plurality of mechanical components, to the main body of the exposure apparatus and connecting wiring and piping, and then carrying out overall adjustments (electrical adjustments and operation confirmation and the like). Moreover, the manufacture of the projection exposure apparatus should preferably be conducted in a clean room where temperature cleanliness and the like are controlled.

Furthermore, it is clear that the present invention is not limited to scan exposure type projection exposure apparatus such as in step and scan systems, but can also be applied to one shot exposure type projection exposure apparatus such as a stepper system.

Hence, the present invention is not limited to the embodiment described above, and provided the gist of the invention is retained, includes all manner of other constructions. Furthermore, the present application also incorporates by reference, all the contents of the disclosure, including the specification, the claims, the drawings and the abstract, of Japanese Patent Application No. 9-342783, filed on December 12, 1997.

### INDUSTRIAL APPLICABILITY

A projection exposure apparatus and a projection exposure method of the present invention uses a projection magnification set within the range 1/5 to 1/10, and therefore offers the advantages of a reduction in the effect of mask pattern drawing error, and the ability to form patterns which can be transferred to large reticles, which are either currently available or will be available in the near future. Furthermore, the numerical aperture of the projection optical system is at least 0.6, the focal depth, which is determined by the line width controllability, can be set within a practical range. Therefore, the design and manufacture of the projection exposure apparatus is able to be simplified, and moreover the cost of the projection exposure apparatus can be kept down. Alternatively, with a projection optical system of an identical numerical aperture, it is also possible, with the present invention, to achieve a practical focal depth for an even more detailed pattern, enabling even greater miniaturization of semiconductor devices and the like.

Furthermore, in those cases where the present invention is applied to scan exposure type projection exposure apparatus such as a step and scan system, because the exposure area per single exposure can be increased, benefits such as a reduction in the effect of drawing error and an improvement in throughput can be achieved.

Moreover, when the external shape of the mask exceeds a 6 inch square, then even in those cases where the projection magnification is set within the range 1/5 to 1/10, the pattern to be transferred to the substrate is not overly small and the original pattern is able to be drawn on the mask. Consequently the throughput of the exposure step can be increased, thereby enabling an efficient carrying out of the exposure.

In those cases where the external shape of the mask is at least a 9 inch square, and for example the projection magnification is set to 1/6, then the effect of the mask pattern drawing error is reduced, and even if the pattern is detailed, the focal depth based on line width controllability can be widened to a practical level. Furthermore, by using a mask of at least a 9 inch square, at least two original patterns of a second generation chip pattern of a 1 gigabit DRAM, for example, can be drawn on the mask, thereby enabling an improvement in the throughput of the exposure step.

Moreover, with a method of manufacturing a device according to the present invention, because a projection exposure apparatus of the present invention is used, the focal depth based on line width controllability deepens. Consequently, a detailed pattern can be formed with a high level of line width control precision. As a result, high performance devices can be manufactured.

## Claims

1. A projection exposure apparatus comprising a projection optical system that projection exposes a pattern image formed on a mask onto a substrate,
wherein a projection magnification of said projection optical system, that transfers the pattern image from said mask to said substrate, is set at a value no greater than 1/5 and no less than 1/10, and a numerical aperture of said projection optical system is set to a value of at least 0.6.

2. A projection exposure apparatus according to claim 1, further comprising a stage system that synchronously moves said mask and said substrate relative to said projection optical system, and wherein during exposure, said mask and said substrate are synchronously scanned relative to said projection optical system using said projection magnification of said projection optical system as a speed ratio.

3. A projection exposure apparatus according to either one of claim 1 and claim 2, wherein light of a wavelength of at least 200 nm is used as illuminating light for exposure, and a numerical aperture of said projection optical system is at least 0.65.

4. A projection exposure apparatus according to either one of claim 1 and claim 2, wherein light of a wavelength less than 200 nm is used as illuminating light for exposure.

5. A projection exposure apparatus according to claim 4, wherein said illuminating light for exposure has a coherence factor of 0.75 to 0.8.

6. A projection exposure apparatus according to any one of claims 3 to 5, wherein 2/3 orbicular zone illumination is performed.

7. A projection exposure apparatus according to claim 6, wherein a ring shaped aperture stop with an inner diameter 2/3 that of an outer diameter is provided in a light path of said illuminating light.

8. A projection exposure apparatus according to any one of claims 1 to 7, wherein an external shape of said mask is larger than a 6 inch square.

9. A projection exposure apparatus according to claim 8, wherein said external shape of said mask is larger than a 9 inch square.

10. A projection exposure apparatus according to either one of claim 1 and claim 2, further comprising a mask stage that supports a mask larger than a 6 inch square as said mask, and a substrate stage that supports said substrate.

11. A method of manufacturing a projection exposure apparatus that projection exposes a pattern image formed on a mask through a projection optical system and onto a substrate, comprising the steps of:
providing a mask stage that supports said mask;
providing a substrate stage that supports said substrate;
mounting a projection optical system, in which a projection magnification from said mask relative to said substrate is set at a value no greater than 1/5 and no less than 1/10, on a support base; and
adjusting a numerical aperture of said projection optical system to a value of at least 0.6.

12. A method of manufacturing a projection exposure apparatus according to claim 11, further comprising the step of:
providing a stage system that synchronously moves said mask and said substrate relative to said projection optical system in order to synchronously scan during exposure said mask and said substrate relative to said projection optical system using said projection magnification of said projection optical system as a speed ratio.

13. A method of manufacturing a projection exposure apparatus according to either one of claim 11 and claim 12, wherein light of a wavelength of at least 200 nm is used as illuminating light for exposure, and a numerical aperture of said projection optical system is at least 0.65.

14. A method of manufacturing a projection exposure apparatus according to either one of claim 11 and claim 12, wherein light of a wavelength less than 200 nm is used as illuminating light for exposure.

15. A method of manufacturing a projection exposure apparatus according to claim 14, wherein said illuminating light for exposure has a coherence factor of 0.75 to 0.8.

16. A method of manufacturing a projection exposure apparatus according to any one of claims 13 to 15, wherein 2/3 orbicular zone illumination is performed.

17. A method of manufacturing a projection exposure apparatus according to claim 16, wherein a ring shaped aperture stop with an inner diameter 2/3 that of an outer diameter is provided in a light path of said illuminating light.

18. A method of manufacturing a projection exposure apparatus according to any one of claims 11 to 17, wherein an external shape of said mask is larger than a 6 inch square.

19. A method of manufacturing a projection exposure apparatus according to claim 18, wherein said external shape of said mask is larger than a 9 inch square.

20. A method of manufacturing a projection exposure apparatus according to either one of claim 11 and claim 12, wherein said mask stage is a mask stage for supporting a mask which is larger than a 6 inch square.

21. A projection exposure method for projection exposing a pattern image formed on a mask through a projection optical system and onto a substrate, comprising the steps of:
using a mask of an external shape of at least a 9 inch square as said mask;
adjusting a projection magnification of said projection optical system from said mask relative to said substrate at a value no greater than 1/5 and no less than 1/10; and
adjusting a numerical aperture of said projection optical system to a value of at least 0.6.

22. A projection exposure method according to claim 21, wherein during exposure, said mask and said substrate are synchronously scanned relative to said projection optical system using said projection magnification of said projection optical system as a speed ratio.

23. A projection exposure method according to either one of claim 21 and claim 22, wherein a projection magnification of said projection optical system from said mask relative to said substrate is adjusted at a value no greater than 1/8 and no less than 1/10, and an external shape of said mask is at least a 12 inch square.

24. A method of manufacturing a device using a projection exposure apparatus according to either one of claim 1 and claim 2, comprising:
a first step for applying a photosensitive material to said substrate;
a second step for projection exposing a pattern image of said mask through said projection optical system and onto said substrate;
a third step for developing said substrate; and
a fourth step forming an uneven pattern on said substrate with photosensitive material remaining after said third step masking said substrate.

25. A device which has been manufactured using a projection exposure apparatus manufactured by a method of manufacturing a projection exposure apparatus according to either one of claim 11 and claim 12.
